# EUROPÄISCHE PATENTSCHRIFT

(11) **EP 4 312 030 B1**
(45) Veröffentlichungstag und Bekanntmachung des Hinweises auf die Patenterteilung: **31.07.2024**
(21) Anmeldenummer: 23177261.7
(22) Anmeldetag: 05.06.2023
(51) Int. Cl.: G01R 1/04

(54) **MULTIMETER**
MULTIMETER
MULTIMÈTRE

(30) Priorität: 28.07.2022 DE 102022118944
(43) Veröffentlichungstag der Anmeldung: 31.01.2024
(73) Patentinhaber: Conrad Electronic SE, 92240 Hirschau (DE)
(72) Erfinder: LEHNER, Harald, 92712 Pirk (DE); STORCH, Susanne, 95643 Tirschenreuth (DE)
(74) Vertreter: Stippl Patentanwälte

(56) Entgegenhaltungen:
- EP-B1- 2 672 278
- US-A1- 2016 202 092
- US-B2- 6 812 685

## Beschreibung

Die vorliegende Erfindung betrifft ein Multimeter gemäß dem Oberbegriff des Anspruchs 1.

### Technologischer Hintergrund

Ein Multimeter ist ein elektrotechnisches Messgerät, das für unterschiedliche elektrische Messgrößen und/oder Messbereiche einsetzbar ist. Üblicherweise kann mit einem Multimeter eine Spannung, ein Strom und/oder ein elektrischer Widerstand gemessen werden. In der Regel können mit einem Multimeter Gleichströme sowie auch Wechselströme erfasst werden. Um zwischen den Messgrößen und/oder Messbereichen umzuschalten, weisen Multimeter üblicherweise Drehschalter auf. Die Messwerte und Einstellungen können über eine Anzeige abgelesen werden.

Die Erfassung der elektrischen Größen erfolgt regelmäßig über zwei Messleitungen, die über Stecker an Anschlussbuchsen des Multimeters angeschlossen werden. Die Messleitungen weisen ein stabförmiges Element mit einem Kontaktelement (Kontaktstift) auf. Die Kontaktelemente der Messleitungen können jeweils mit einer Messstelle kontaktiert werden, wobei zwischen den Messstellen ein Strom, eine Spannung oder ein elektrischer Widerstand bestimmt werden kann.

### Druckschriftlicher Stand der Technik

Die DE 10 2019 116 098 A1 offenbart ein Strom- und Spannungsmessgerät mit einer mechanischen Befestigungsvorrichtung für ein stabförmiges Element einer Messleitung. Die mechanische Befestigung von Messspitzen erfolgt hierbei über eine Schwalbenschwanzführung. Derartige mechanische Befestigungen unterliegen in nachteiliger Weise einem gewissen Verschleiß, mit der Folge, dass der Halt der mechanischen Befestigung mit der Anzahl der Befestigungs- bzw. Lösevorgänge nachlässt. Zudem ist ein Befestigen und Lösen der Messspitzen mit einer Hand nur bedingt möglich. Außerdem erfordert eine derartige Befestigung eine vergleichsweise aufwendige Konstruktion.

Die DE 10 2012 016 702 A1 offenbart eine Befestigung von technischen Geräten, z.B. einem Multimeter, an einer Oberfläche unter Verwendung von einem oder mehreren Magneten, die sich in einer Aussparung am Gerätegehäuse befinden. Die Aussparung ist an der Gerätegehäuseseite, die an der Oberfläche befestigt wird, offen ausgestaltet.

Aus der US 2016/202092 A1 offenbart ein Multimeter, an dessen Gehäuserückseite sich ein hervorstehender Abschnitt mit einem länglichen Schlitz befindet, wobei ein Magnet in oder in der Nähe des länglichen Schlitzes positioniert ist. Ein mit einer Messleitung verbundener Kontaktstift umfasst eine längliche, hervorragende Metallplatte, die so geformt ist, dass sie in den länglichen Schlitz passt und für magnetischen Eingriff mit dem Magneten sorgt.

Die EP 2 672 278 A1 betrifft ein Messinstrument, insbesondere einen Spannungsprüfer, mit zwei Tastköpfen, die in separaten Gehäusen angeordnet sind, sowie mit einem Kabel, an dem die Gehäuse angeordnet und miteinander verbunden sind, wobei die Gehäuse der Spannungsprüfer bzw. der Tastköpfe sich magnetisch anziehend ausgebildet sind. Dabei ist entweder an zumindest einem der Gehäuse ein Magnet angeordnet und zumindest ein Teil des anderen Gehäuses aus einem magnetisch leitfähigen Material gefertigt, oder an jedem der Gehäuse jeweils wenigstens ein Magnet vorgesehen, wobei die Magnete gegensätzlich zueinander gepolt sind. Korrespondierend zur Anordnung der Magnete an dem anderen Gehäuse sind Ausnehmungen im Gehäusemantel vorgesehen, durch die ein elektrisch leitender Teil des anderen Gehäuses zugänglich ist, oder andere, entgegengesetzt gepolte Magnete.

Aus der US 6 812 685 B2 ist ein elektrisches Prüfgerät mit den Funktionen berührungslose Wechselspannungsmessung, Einzelkontakt-Wechselspannungsmessung und Spannungsmessung bekannt. Mit Hilfe von zwei Spannungsmessfühlern können genauere Informationen über die Höhe der Spannung ermittelt werden. Wenn die beiden Spannungsmessfühler nicht in Gebrauch sind, können sie in zwei offenen Taschen eines Aufbewahrungsbereichs für Messleitungen an der Rückwand des Gehäuses zur Aufbewahrung eingeschnappt werden.

### Aufgabe der vorliegenden Erfindung

Die Aufgabe der vorliegenden Erfindung besteht darin, ein Multimeter mit einer verbesserten Bedienbarkeit zur Verfügung zu stellen.

### Lösung der Aufgabe

Die vorstehende Aufgabe wird durch die gesamte Lehre des Anspruchs 1 gelöst. Zweckmäßige Ausgestaltungen der Erfindung sind in den Unteransprüchen beansprucht.

Erfindungsgemäß ist mittels einer in das Gehäuse integrierten Magnetanordnung das Multimeter über seine Gehäuserückseite an einer ferromagnetischen Anlagefläche mittels magnetischer Anziehungskraft fixierbar. Dies ermöglicht es der Bedienperson, das Multimeter z.B. an der Tür eines Schaltschranks oder an einem Karosserieteil eines Fahrzeugs unmittelbar zu fixieren. Hierdurch kann das Multimeter vergleichsweise nahe an der Messposition angeordnet werden. Zudem ist es fest fixiert und gut ablesbar. Die Erfindung erlaubt es, dass das Multimeter sogar an Schrägen oder senkrechten Flächen sicher fixiert werden kann. Daneben sind auch der erste sowie zweite Kontaktstift mittels der in das Gehäuse integrierten Magnetanordnung an der Gehäuserückseite mittels magnetischer Anziehungskraft fixierbar. Hierdurch wird eine sichere Fixierung bei einfacher Handhabbarkeit ermöglicht. Durch die Magnetanordnung ist der Befestigungs- bzw. Lösevorgang verschleißfrei. Zudem kann das Befestigen und/oder Lösen mit einer Hand erfolgen. Außerdem kann eine Bedienperson z.B. mit dem Multimeter sowie einem per Magnetkraft am Multimeter fixierten Kontaktstift in der einen Hand sowie dem zweiten, aus der Fixierung gelösten, Kontaktstift in der anderen Hand in einfacher Weise eine Messung durchführen und gleichzeitig den Messstand gut ablesen. Hierdurch kann die Ablesbarkeit während der Bedienung erheblich verbessert werden.

Erfindungsgemäß sind der erste und zweite Kontaktstift per Magnetkraft in einer ersten sowie zweiten Position an der Gehäuserückseite fixierbar, wobei die erste Position eine Lagerposition und die zweite Position eine Arbeitsposition ist. In der Arbeitsposition kann zumindest einer der beiden Kontaktstifte derart fixiert sein, dass seine Spitze über das Gehäuse übersteht. In besonders vorteilhafter Weise können die Kontaktstifte in der Lagerposition beispielsweise für den Transport befestigt werden. In der Arbeitsposition kann das Multimeter mit zumindest einem Kontaktstift eine Einheit bilden, wobei der Kontaktstift zusammen mit dem Multimeter mit einer Hand mit der einen Messstelle kontaktierbar ist, wohingegen mit der anderen Hand der zweite Kontaktstift gehalten werden kann.

In der Arbeitsposition wird vorzugsweise eine im Vergleich zur Lagerposition stärkere magnetische Kraft bewirkt. Dies geschieht beispielsweise dadurch, dass sich die Magnete in der Arbeitsposition mit den ferromagnetischen oder weichmagnetischen Einlagen im Gegensatz zur Lagerposition vollständig überlappen.

Zweckmäßigerweise kann zusätzlich zur Fixierung mittels der Magnetanordnung in der Lagerposition und/oder Arbeitsposition eine mechanische, in Längsrichtung des jeweiligen Kontaktstifts wirkende Positionsverriegelung des jeweiligen Kontaktstifts vorgesehen sein. Dadurch kann die Befestigung bzw. Fixierung noch zusätzlich verbessert werden.

Diese Positionsverriegelung kann durch einen vorzugsweise quer zur Längsachse des Kontaktstifts verlaufenden, vorzugsweise umfänglich umlaufenden Vorsprung am jeweiligen Kontaktstift, der in eine komplementäre Ausnehmung am Gehäuse oder umgekehrt eingreift, erfolgen. Dadurch können laterale Bewegungen des Kontaktstifts während des Gebrauchs verhindert werden.

In einer zweckmäßigen Ausgestaltung kann die Magnetanordnung mindestens einen innerhalb des Gehäuses angeordneten, dem jeweiligen ersten oder zweiten Kontaktstift lokal zugeordneten Magneten umfasst.

Die Haltekraft kann erhöht werden, indem dem jeweiligen ersten oder zweiten Kontaktstift mehrere Magnete zugeordnet sind. Hierbei können die Magnete derart angeordnet sein, dass sie den jeweiligen Kontaktstift in der jeweiligen Lager- bzw. Arbeitsposition des jeweiligen Kontaktstifts sichern.

Dadurch, dass die Magnetanordnung an der Innenwand der Gehäuserückseite befestigt ist, ist die Magnetanordnung geschützt und durch die Gehäuserückseite abgedeckt. Die Gehäuserückseite ist zumindest im Bereich der Magnetanordnung zumindest im Wesentlichen eben ausgebildet.

In vorteilhafter Weise können die Magnete der Magnetanordnung Neodym-Magnete sein. Diese weisen eine besonders starke magnetische Haltekraft auf.

Zweckmäßigerweise besitzt der jeweilige Kontaktstift einen Griffbereich aus Kunststoff, der mindestens eine ferromagnetische Einlage beinhaltet. Vorzugsweise sind mindestens zwei ferromagnetische Einlagen vorgesehen. Letztere können der jeweiligen Lager- bzw. Arbeitsposition der Kontaktstifte zugeordnet sein.

Die ferromagnetische Einlage kann dazu mit Kunststoff umspritzt sein.

In einer vorteilhaften Ausgestaltung kann der erste und/oder zweite Kontaktstift mindestens einen im Wesentlichen parallel zur Achse des Kontaktstifts verlaufenden, gerundeten oder abgeflachten Kontaktbereich aufweisen. Dadurch kann beispielsweise die Auflagefläche des Kontaktstifts an der Gehäuserückseite vergrößert und die magnetische Haftkraft verbessert werden.

In weiterer Ausgestaltung kann der erste und/oder zweite Kontaktstift in Umfangsrichtung drei im Wesentlichen parallel zur Achse des Kontaktstifts verlaufende, abgeflachte Kontaktbereiche aufweisen. Dadurch wird beispielsweise eine besonders ergonomische Form des Kontaktstifts erreicht.

In weiterer Ausgestaltung kann an der Gehäuserückseite im Bereich der Magnetanordnung eine erste sowie zweite Auflagevertiefung für den ersten sowie zweiten Kontaktstift vorgesehen sein. Diese Auflagevertiefung kann insbesondere an die Form des jeweiligen Kontaktstifts, zumindest über einen Teilbereich desselben, angepasst sein.

Ferner kann an der Gehäuserückseite, vorzugsweise unterhalb des Bereichs der Magnetanordnung, ein herausschwenkbarer und zur Gehäuserückseite hin schräg positionierbarer Standfuß vorgesehen sein. Dadurch kann das Multimeter bei Bedarf auch schräg auf einer Ablagefläche positioniert und hierdurch die Sicht auf die Anzeige verbessert werden. Der Standfuß befindet sich vorzugsweise unterhalb der Magnetanordnung bezogen auf die Gehäuseoberseite.

### Beschreibung der Erfindung anhand von Ausführungsbeispielen

Zweckmäßige Ausgestaltungen der vorliegenden Erfindung werden anhand von Zeichnungsfiguren nachstehend näher erläutert. Es zeigen:
- Fig. 1: eine Vorderansicht eines Ausführungsbeispiels eines Multimeters,
- Fig. 2: eine Rückansicht des Multimeters nach Fig. 1,
- Fig. 3: eine perspektivische Ansicht des Multimeters nach Fig. 1 mit einem ausgeklappten Standfuß,
- Fig. 4: eine Vorderansicht eines Ausführungsbeispiels eines stabförmigen Kontaktstifts einer Messleitung eines Multimeters,
- Fig. 5: eine seitliche Schnittansicht eines Teilbereichs des Kontaktstifts nach Fig. 4 von links betrachtet,
- Fig. 6: eine Draufsicht auf den Kontaktstift nach Fig. 4,
- Fig. 7: eine perspektivische Ansicht eines Multimeters nach Fig. 1 mit zwei an der Rückseite des Multimeters in einer Lagerposition angebrachten Messleitungen nach Fig. 4,
- Fig. 8: eine perspektivische Ansicht eines Multimeters nach Fig. 1 mit einer an der Rückseite des Multimeters in einer Arbeitsposition angebrachten Messleitung nach Fig. 4,
- Fig. 9: eine Rückansicht eines alternativen Ausführungsbeispiels eines Multimeters sowie
- Fig. 10: eine Rückansicht des alternativen Ausführungsbeispiels eines Multimeters nach Fig. 9 mit zwei an der Rückseite des Multimeters in einer Lagerposition angebrachte Messleitungen nach Fig. 4.

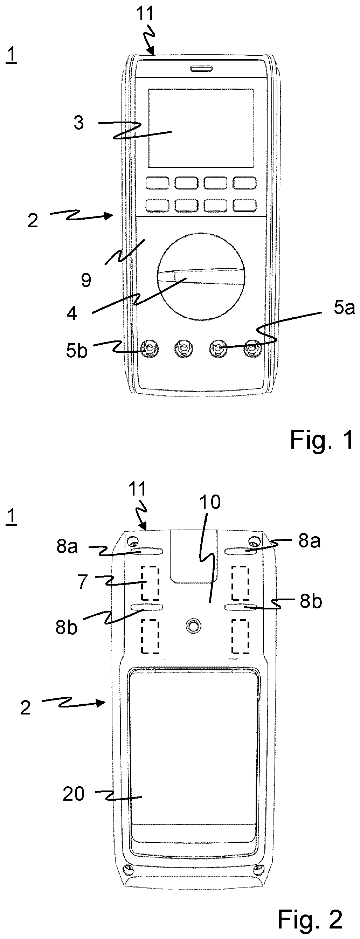

Fig. 1 zeigt die Vorderseite eines erfindungsgemäßen Multimeters 1 zum Messen unterschiedlicher elektrischer Größen, beispielsweise Strom, Spannung oder elektrischer Widerstand. Das Multimeter 1 weist ein Gehäuse 2 mit einer Gehäusevorderseite 9 und einer Gehäuseoberseite 11 auf. An der Gehäusevorderseite 9 sind eine Anzeige 3 zum Anzeigen von Einstellungen, z.B. der zu messenden Größe, sowie von Messwerten, z.B. einem Spannungswert, einem Stromwert oder einem Widerstandswert, sowie Taster angeordnet. Weiterhin ist ein Umschalter 4 in Form eines Drehschalters zum Auswählen der zu messenden Größe sowie zum Ein- und Ausschalten des Multimeters 1 vorgesehen. Im unteren Bereich der Gehäusevorderseite 9 befinden sich Anschlussbuchsen 5a, 5b zum Anschließen von in Fig. 1 nicht dargestellten Messleitungen.

Fig. 2 zeigt die Gehäuserückseite 10 des Multimeters 1 nach Fig. 1. In dem der Gehäuseoberseite 11 zugewandten Bereich der Gehäuserückseite 10 ist eine Magnetanordnung mit z.B. vier Magneten 7 vorgesehen. Bei den Magneten 7 handelt es sich vorzugsweise um Neodym-Magnete. Die Magnete 7 sind auf der Innenseite der Gehäuserückseite 10 angeordnet und werden vom Gehäuse 2 verdeckt. Aus darstellerischen Gründen sind die Magnete 7 daher gestrichelt gezeichnet. Die Gehäuserückseite 10 besteht beispielsweise aus einem nichtmagnetischen Kunststoff. Das Magnetfeld der Magnete 7 kann daher das Gehäuse 2 durchdringen. Erfindungsgemäß sind die Magnete 7 dazu vorgesehen, eine magnetische Verbindung mit einem oder zwei nicht dargestellten stabförmigen Kontaktstiften einer Messleitung zu bewirken und zwar zum einen in einer Lagerposition und zum anderen in einer Arbeitsposition. Die Magnete 7 sind so angeordnet, dass deren Haltekraft in Arbeitsposition größer ist als in Lagerposition. Des Weiteren kann durch die Magnete 7 das Multimeter 1 an einer nicht dargestellten ferromagnetischen bzw. weichmagnetischen Anlagefläche, beispielsweise an einem Schaltschrank oder an einem Karosserieteil eines Fahrzeugs in einfacher Weise befestigt werden.

An der Gehäuserückseite 10 sind beidseitig jeweils zwei längliche, quer zur Längserstreckung des Multimeters 1 verlaufende, Ausnehmungen 8a, 8b angeordnet. Die Ausnehmungen 8a, 8b sind dazu vorgesehen, jeweils eine formschlüssige Verbindung mit einem korrespondierenden Vorsprung eines stabförmigen Kontaktstifts einer Messleitung zu bewirken und damit eine Positionsverriegelung in Längsrichtung zum fixierten Kontaktstift bzw. quer zur Erstreckung der jeweiligen Ausnehmung 8a, 8b zu begründen. Die beiden Ausnehmungen 8a, 8b sind unterschiedlich zur Gehäuseoberseite 11 beabstandet. Eine Ausnehmung 8a repräsentiert die Lage bzw. Anordnung des Kontaktstifts in Arbeitsposition, wohingegen die andere Ausnehmung 8b die Lage bzw. Anordnung des Kontaktstifts in Lagerposition repräsentiert.

Ferner befindet sich im unteren Bereich der Gehäuserückseite 10 ein herausschwenkbarer, in Fig. 2 eingeklappter, Standfuß 20.

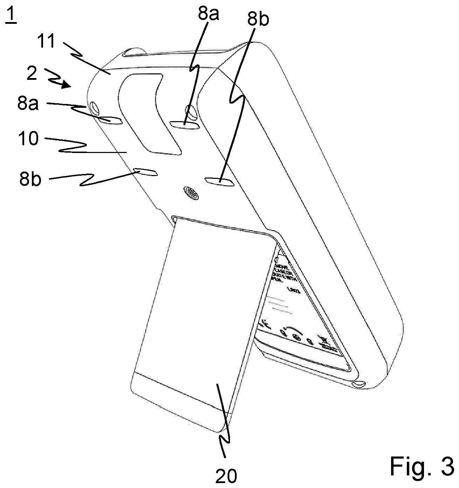

Fig. 3 zeigt das Multimeter 1 mit ausgeklapptem Standfuß 20. Durch den Standfuß 20 kann das Multimeter 1 auch in einer schrägen Position aufgestellt werden, wodurch die Anzeige 3 besser abgelesen werden kann, als wenn das Multimeter 1 beispielsweise auf einer waagerechten Auflagefläche abgelegt ist. Der Standfuß 20 befindet sich unterhalb der Magnetanordnung bezogen auf die Gehäuseoberseite 11. Er liegt im eingeklappten Zustand in einer Gehäuseausnehmung an der Gehäuserückseite ein.

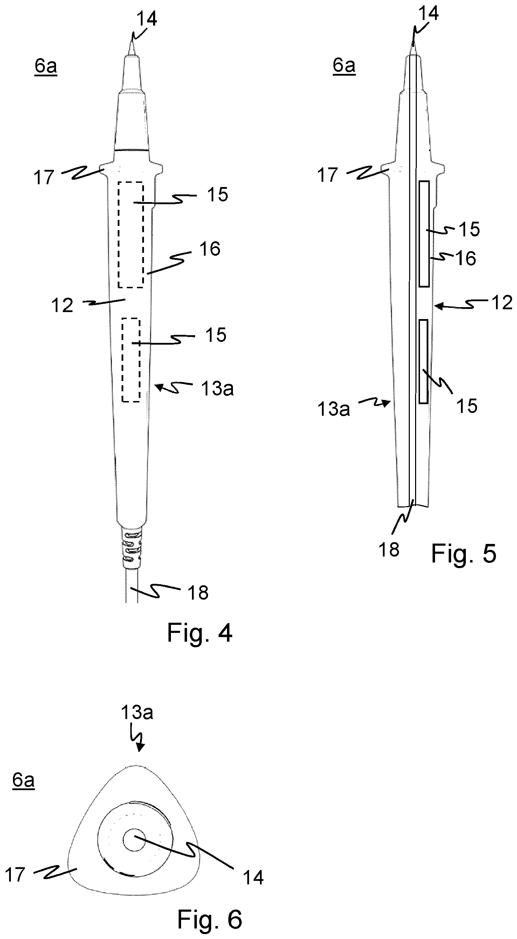

Fig. 4, 5 und 6 zeigen jeweils beispielhaft einen stabförmigen Kontaktstift 13a einer Messleitung 6a in einer Seitenansicht, einer seitlichen Schnittansicht und einer Draufsicht. Der zweite Kontaktstift 13b des Multimeters 1 ist entsprechend ausgebildet.

Gemäß Fig. 4 befindet sich am unteren Bereich des Kontaktstifts 13a ein flexibles Kabel 18. Am anderen nicht dargestellten Ende des Kabels 18 ist ein Stecker, z.B. ein Bananenstecker, zum Anschluss an die Anschlussbuchse 5a des Multimeters 1 vorgesehen (vgl. Fig. 1). An der dem Kabel 18 gegenüberliegenden Seite des Kontaktstifts 13a befindet sich ein Kontaktelement 14, vorzugsweise in Form einer Kontaktspitze. Weiterhin umfasst der Kontaktstift 13a einen zu seiner Längsachse verlaufenden abgeflachten Kontaktbereich 12, der gleichzeitig den elektrisch isolierenden Griffbereich 16 des Kontaktstifts 13a bildet. Auf der Innenseite des elektrisch isolierenden Griffbereichs 16 des Kontaktstifts 13a befinden sich ferromagnetische, beispielsweise weichmagnetische, Einlagen 15, die in Fig. 4 gestrichelt wiedergegeben sind.

Des Weiteren ist an dem Kontaktstift 13a ein umlaufender Vorsprung 17 vorgesehen, der eine formschlüssige Verbindung mit einer der in Fig. 2 und 3 dargestellten Ausnehmungen 8a oder 8b des Multimeters 1 eingeht und damit eine in Längsrichtung wirkende Positionsverriegelung bewirkt.

Fig. 5 zeigt eine um 90° gedrehte seitliche Schnittansicht des Kontaktstifts 13a aus Fig. 4. Das Kontaktelement 14 ist über den elektrischen Leiter im Inneren des Kabels 18 mit dem nicht dargestellten Stecker elektrisch verbunden. Auf der Innenseite des elektrisch isolierenden Griffbereichs 16 des Kontaktstifts 13a befinden sich die ferromagnetischen, beispielsweise weichmagnetischen, Einlagen 15. Die Anordnung kann erzeugt werden, indem die ferromagnetischen Einlagen 15 mit Kunststoff umspritzt werden. Die Einlagen 15 sind dazu vorgesehen, mit den in Fig. 5 nicht dargestellten Magneten 7 des Multimeters 1 eine magnetische Verbindung zu bewirken (vgl. Fig. 2). Der Griffbereich 16 besteht aus einem nichtmagnetischen Kunststoff. Das von den Magneten 7 erzeugte Magnetfeld kann daher den Griffbereich 16 durchdringen.

Die Einlagen 15 können in Längsrichtung des Kontaktstifts 13a betrachtet hintereinander positioniert sein und den jeweiligen Magneten 7 der Magnetanordnung zugeordnet sein. In der Arbeitsposition überlappen beide Magnete 7 der Magnetanordnung die beiden Einlagen 15, wohingegen in der Lagerposition die obere Einlage 15 mit dem unteren Magneten 7 der Magnetanordnung zusammenwirkt. Auf diese Weise wird ein verstärkter magnetischer Halt in der Arbeitsposition im Vergleich zur Lagerposition bewirkt.

Fig. 6 zeigt den Kontaktstift 13a der Messleitung 6a aus Fig. 4 in einer Draufsicht. Der Vorsprung 17 ist aus dieser Sicht betrachtet im Wesentlichen abgerundet dreieckförmig. Der Kontaktstift 13a weist, bezüglich dieser Draufsicht dahinterliegend und von dem Vorsprung 17 verdeckt, drei abgeflachte Kontaktbereiche 12 auf. Die Kontaktbereiche 12 erstrecken sich jeweils entlang des Griffbereichs 16. Der Querschnitt des Kontaktstifts 13a ist im Griffbereich 16 im Wesentlichen ebenfalls dreieckförmig. Dadurch ist der Kontaktstift 13a besonders ergonomisch und kann gut mit drei Fingern gehalten werden.

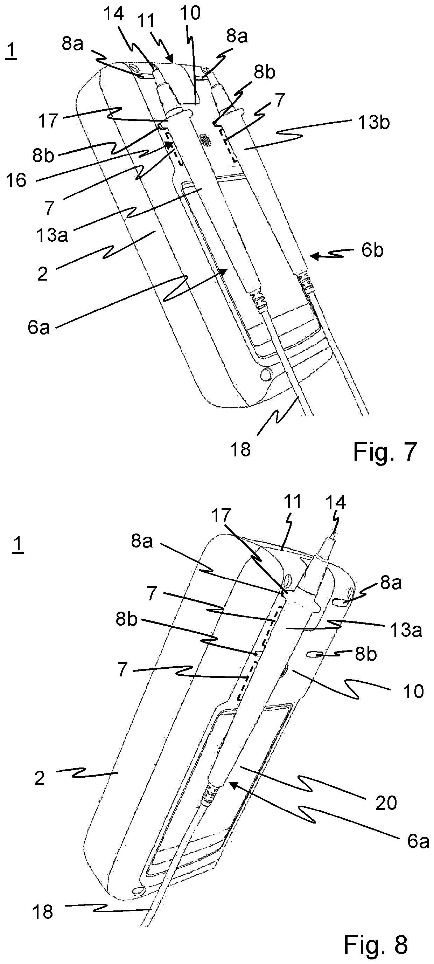

Fig. 7 zeigt ein Multimeter 1 mit zwei magnetisch befestigten Kontaktstiften 13a, 13b zweier Messleitungen 6a, 6b in der Lagerposition. Der Kontaktstift 13b weist den gleichen Aufbau und die gleichen Elemente wie der Kontaktstift 13a auf (vgl. Fig. 4 bis 6). Die Lagerposition dient der Aufbewahrung bzw. dem Lagern der Messleitungen 6a, 6b, beispielsweise bei einem Transport der Multimeters 1. Die Kontaktstifte 13a, 13b liegen jeweils mit ihrem Kontaktbereich 12 an der Gehäuserückseite 10 des Multimeters 1 an und sind jeweils über ihre obere ferromagnetischen oder weichmagnetischen Einlagen 15 mit den unteren Magneten 7 (gestrichelt gezeichnet) des Multimeters 1 magnetisch verbunden. Dadurch kann der jeweilige Kontaktstift 13a, 13b vom Multimeter 1, beispielsweise mit einer Hand, in einfacher Weise gelöst und bei Bedarf rasch wieder befestigt werden. Hierbei liegt der Vorsprung 17 des jeweiligen Kontaktstifts 13a, 13b formschlüssig jeweils in einer Ausnehmung 8b des Multimeters 1. Hierdurch können in Längsrichtung erfolgende Bewegungen der Kontaktstifte 13a, 13b bezüglich der Gehäuserückseite 10 verhindert bzw. eingeschränkt werden. Es kann somit eine in Längsrichtung wirkende Positionsverriegelung bewirkt werden. Der Abstand der jeweiligen Ausnehmung 8b bzw. der Abstand der Magnete 7 bezüglich der Gehäuseoberseite 11 ist vorzugsweise so dimensioniert, dass die Kontaktelemente 14 die Gehäuseoberseite 11 nicht überragen.

Beim Halten des zweiten Kontaktstifts 13b dient der Vorsprung 17 zudem als fühlbare mechanische Anlage für die Finger. Hierdurch wird ein Übergreifen beim Messen einer stromführenden Messstelle vermieden.

Fig. 8 zeigt ein Multimeter 1 mit einem magnetisch daran befestigten Kontaktstift 13a einer Messleitung 6a in Arbeitsposition, d.h. einer Position, um eine Messung mit diesem Kontaktstift 13a durchzuführen. Der Kontaktstift 13a liegt hierbei mit seinem Kontaktbereich 12 an der Gehäuserückseite 10 des Multimeters 1 an und ist über seine beiden Einlagen 15 mit den beiden Magneten 7 (gestrichelt gezeichnet) des Multimeters 1 magnetisch verbunden. Dadurch wird ein besonders fester und sicherer Halt in dieser Arbeitsposition bzw. Messposition gewährleistet. Der Vorsprung 17 des Kontaktstift 13a liegt in der Arbeitsposition in der Ausnehmung 8a die sich näher an der Gehäuseoberseite 11 befindet als die Ausnehmung 8b für die Lagerposition (vgl. Fig. 7). Dadurch überragt das Kontaktelement 14 die Gehäuseoberseite 11. Das Kontaktelement 14 kann auf diese Weise mit einer Hand in der montierten Position, d.h. der Arbeitsposition, mit einer Messstelle kontaktiert werden. Dementsprechend kann eine Messung einer elektrischen Größe der Anordnung gemäß Fig. 8 erfolgen, indem das Kontaktelement 14 des an dem Multimeter 1 befestigten Kontaktstifts 13a mit einer ersten nicht dargestellten Messstelle kontaktiert wird. Das Kontaktelement 14 des Kontaktstifts 13a ist über das Kabel 18 und einen, in Fig. 8 durch das Multimeter 1 verdeckten, Stecker elektrisch mit der Anschlussbuchse 5a des Multimeters 1 verbunden. Weiterhin wird das zweite nicht dargestellte Kontaktelement 14 des Kontaktstifts 13b der zweiten Messleitung 6b mit einer zweiten Messstelle kontaktiert, wobei die zweite Messleitung 6b elektrisch über einen Stecker mit der Anschlussbuchse 5b des Multimeters 1 verbunden ist. Dadurch kann bei einer Messung der mit dem Multimeter 1 magnetisch verbundene Kontaktstifts 13a zusammen mit dem Multimeter 1 in einer Hand und der zweite Kontaktstifts 13b in der anderen Hand gehalten werden.

Bei Bedarf können auch beide Kontaktstifte 13a, 13b mit jeweils einem Kontaktelement 14 mit dem Multimeter 1 in der Arbeitsposition magnetisch und über die jeweilige Anschlussbuchse 5a, 5b elektrisch verbunden sein. Die Kontaktelemente 14 der Kontaktstifte 13a, 13b überragen hierbei beide die Gehäuseoberseite 11 und sind im Wesentlichen parallel und beabstandet zueinander angeordnet. In dieser Anordnung kann beispielweise ein bedrahtetes elektrisches Bauelement, z.B. ein Metallschichtwiderstand, mit jeweils einem seiner Drähte an jeweils ein Kontaktelement 14 gehalten und damit beispielsweise der elektrische Widerstand des Bauelements gemessen werden. Ferner kann die Beabstandung der beiden Kontaktelemente 14 bzw. der Kontaktstifte 13a, 13b derart dimensioniert sein, dass dieser beispielsweise dem Abstand der Kontakte eines Steckers für eine Steckdose entspricht. Dadurch kann in einfacher Weise mit lediglich einer Hand eine an einer Steckdose anliegende Spannung gemessen werden.

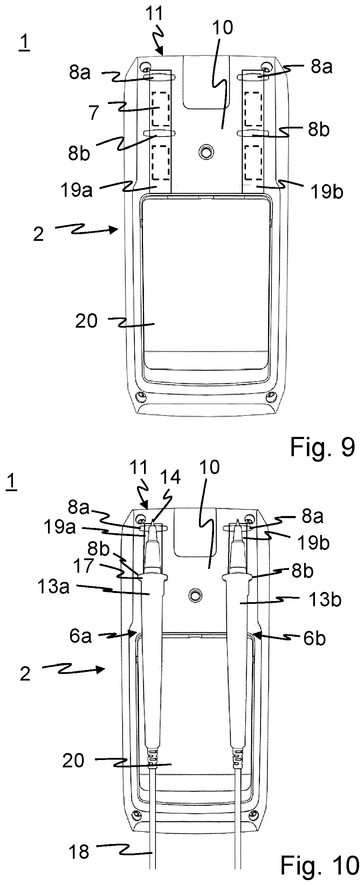

Fig. 9 und 10 zeigen eine alternative Ausgestaltung eines Multimeters 1.

Gemäß Fig. 9 sind an der Gehäuserückseite 10 zusätzlich zwei längliche Auflagevertiefungen 19a, 19b vorgesehen, die in Richtung der Längserstreckung des Multimeters 1 und parallel zueinander angeordnet sind. Die Vertiefungen 19a, 19b sind für die beiden Kontaktstifte 13a, 13b vorgesehen und können eine zusätzliche formschlüssige Verbindung bezüglich lateraler Bewegungen der Kontaktstifte 13a, 13b, d.h. eine zusätzliche Positionsverriegelung, bewirken. Hierdurch kann ein noch besserer Halt erreicht werden. Die Ausgestaltung des Multimeters 1 gemäß Fig. 9 weist abgesehen von den Vertiefungen 19a, 19b die gleichen Elemente wie das Multimeter 1 nach Fig. 1 auf.

Fig. 10 zeigt die Ausgestaltung eines Multimeters 1 gemäß Fig. 9 mit den beiden Kontaktstiften 13a, 13b. Die beiden Kontaktstifte 13a, 13b sind in Fig. 10 in Lagerposition jeweils in der zugehörigen Auflagevertiefung 19a, 19b bzw. Ausnehmung 8b formschlüssig positioniert und mit dem Multimeter 1 magnetisch verbunden.

Es wird ausdrücklich darauf hingewiesen, dass auch die Kombination von Einzelmerkmalen sowie Untermerkmalen als erfindungswesentlich und vom Offenbarungsgehalt der Anmeldung umfasst anzusehen sind.

### BEZUGSZEICHENLISTE

- 1: Multimeter
- 2: Gehäuse
- 3: Anzeige
- 4: Umschalter
- 5a: Anschlussbuchse
- 5b: Anschlussbuchse
- 6a: Messleitung
- 6b: Messleitung
- 7: Magnet
- 8a: Ausnehmung
- 8b: Ausnehmung
- 9: Gehäusevorderseite
- 10: Gehäuserückseite
- 11: Gehäuseoberseite
- 12: Kontaktbereich
- 13a: Kontaktstift
- 13b: Kontaktstift
- 14: Kontaktelement
- 15: Einlage
- 16: Griffbereich
- 17: Vorsprung
- 18: Kabel
- 19a: Auflagevertiefung
- 19b: Auflagevertiefung
- 20: Standfuß

## Patentansprüche

1. Multimeter zum Messen einer Mehrzahl von auswählbaren elektrischen Größen, umfassend:
- ein Gehäuse (2) mit einer Gehäusevorderseite (9) sowie einer der Gehäusevorderseite (9) gegenüberliegenden Gehäuserückseite (10),
- eine Anzeige (3) zum Anzeigen einer Einstellung und/oder eines Messwerts,
- eine erste Messleitung (6a) mit einem ersten stabförmigen Kontaktstift (13a),
- eine zweite Messleitung (6b) mit einem zweiten stabförmigen Kontaktstift (13b),
- einen Umschalter, vorzugsweise einen Drehschalter (4), zum Anwählen der zu messenden elektrischen Größe,
- eine erste Anschlussbuchse (5a) zum Anschließen der ersten Messleitung (6a), sowie
- eine zweite Anschlussbuchse (5b) zum Anschließen der zweiten Messleitung (6b),
- mittels einer in das Gehäuse (2) integrierten Magnetanordnung das Multimeter (1) über seine Gehäuserückseite (10) an einer ferromagnetischen Anlagefläche mittels magnetischer Anziehungskraft fixierbar ist, und
- der erste sowie zweite Kontaktstift (13a, 13b) mittels der in das Gehäuse (2) integrierten Magnetanordnung an der Gehäuserückseite (10) mittels magnetischer Anziehungskraft fixierbar sind,
**dadurch gekennzeichnet, dass**
der erste und zweite Kontaktstift (13a, 13b) in einer ersten sowie zweiten Position an der Gehäuserückseite (10) fixierbar sind, wobei die erste Position eine Lagerposition ist, und wobei die zweite Position eine Arbeitsposition ist, wobei in der Arbeitsposition zumindest einer der beiden Kontaktstifte (13a, 13b) derart fixiert ist, dass seine Spitze über das Gehäuse (2) übersteht.

2. Multimeter nach Anspruch 1, **dadurch gekennzeichnet, dass** zusätzlich zur Fixierung mittels der Magnetanordnung in der Lagerposition und/oder Arbeitsposition eine mechanische, in Längsrichtung des jeweiligen Kontaktstifts (13a, 13b) wirkende Positionsverriegelung des jeweiligen Kontaktstifts (13a, 13b) vorgesehen ist.

3. Multimeter nach einem der vorhergehenden Ansprüche, **dadurch gekennzeichnet, dass** die Positionsverriegelung durch einen vorzugsweise quer zur Längsachse des Kontaktstifts (13a, 13b) verlaufenden, vorzugsweise umfänglich umlaufenden Vorsprung (17) am jeweiligen Kontaktstift (13a, 13b), der in eine komplementäre Ausnehmung (8a, 8b) am Gehäuse (2) oder umgekehrt eingreift, erfolgt.

4. Multimeter nach einem der vorhergehenden Ansprüche, **dadurch gekennzeichnet, dass** die Magnetanordnung mindestens einen innerhalb des Gehäuses (2) angeordneten, dem jeweiligen ersten oder zweiten Kontaktstift (13a, 13b) lokal zugeordneten Magneten (7) umfasst.

5. Multimeter nach Anspruch 4, **dadurch gekennzeichnet, dass** dem jeweiligen ersten oder zweiten Kontaktstift (13a, 13b) mehrere Magnete (7) zugeordnet sind.

6. Multimeter nach einem der vorhergehenden Ansprüche, **dadurch gekennzeichnet, dass** die Magnetanordnung an der Innenwand der Gehäuserückseite (10) befestigt ist.

7. Multimeter nach einem der vorhergehenden Ansprüche, **dadurch gekennzeichnet, dass** die Magnete der Magnetanordnung Neodym-Magnete sind.

8. Multimeter nach einem der vorhergehenden Ansprüche, **dadurch gekennzeichnet, dass** der jeweilige Kontaktstift (13a, 13b) einen Griffbereich (16) aus Kunststoff besitzt und der Griffbereich (16) mindestens eine ferromagnetische Einlage (15), vorzugsweise mindestens zwei ferromagnetische Einlagen beinhaltet.

9. Multimeter nach Anspruch 8, **dadurch gekennzeichnet, dass** die ferromagnetische Einlage (15) mit Kunststoff umspritzt ist.

10. Multimeter nach einem der vorhergehenden Ansprüche, **dadurch gekennzeichnet, dass** der erste oder zweite Kontaktstift (13a, 13b) mindestens einen im Wesentlichen parallel zur Achse des Kontaktstifts (13a, 13b) verlaufenden, gerundeten oder abgeflachten Kontaktbereich (12) aufweist.

11. Multimeter nach Anspruch 10, **dadurch gekennzeichnet, dass** der erste oder zweite Kontaktstift (13a, 13b) drei im Wesentlichen parallel zur Achse des Kontaktstifts (13a, 13b) verlaufende, gerundete oder abgeflachte Kontaktbereiche (12) aufweist.

12. Multimeter nach einem der vorhergehenden Ansprüche, **dadurch gekennzeichnet, dass** an der Gehäuserückseite (10) im Bereich der Magnetanordnung eine erste sowie zweite Auflagevertiefung (19a, 19b) für den ersten sowie zweiten Kontaktstift (13a, 13b) vorgesehen ist.

13. Multimeter nach einem der vorhergehenden Ansprüche, **dadurch gekennzeichnet, dass** an der Gehäuserückseite (10), vorzugsweise unterhalb des Bereichs der Magnetanordnung, ein herausschwenkbarer und zur Gehäuserückseite hin schräg positionierbarer Standfuß (20) vorgesehen ist.

## Claims

1. Multimeter for measuring a plurality of selectable electrical quantities, comprising:
- a housing (2) with a housing front side (9) and a housing rear side (10) situated opposite the housing front side (9),
- a display (3) for displaying a setting and/or a measured value,
- a first measurement lead (6a) with a first rod-shaped contact pin (13a),
- a second measurement lead (6b) with a second rod-shaped contact pin (13b),
- a switch, preferably a rotary switch (4), for selecting the electrical quantity to be measured,
- a first connection socket (5a) for connecting the first measurement lead (6a), and
- a second connection socket (5b) for connecting the second measurement lead (6b),
- by means of a magnet arrangement integrated into the housing (2), the multimeter (1) can be fixed via its housing rear side (10) on a ferromagnetic attachment surface by means of magnetic attraction, and
- the first and second contact pin (13a, 13b) can, by means of the magnet arrangement integrated into the housing (2), be fixed on the housing rear side (10) by means of magnetic attraction,
**characterized in that**
the first and second contact pin (13a, 13b) can be fixed in a first and second position on the housing rear side (10), wherein the first position is a storage position and wherein the second position is a working position, wherein in the working position, at least one of the two contact pins (13a, 13b) is fixed in such a way that its tip protrudes beyond the housing (2).

2. Multimeter according to Claim 1, **characterized in that**, in addition to the fixing by means of the magnet arrangement in the storage position and/or working position, mechanical positional locking, acting in the longitudinal direction of the respective contact pin (13a, 13b), of the respective contact pin (13a, 13b) is provided.

3. Multimeter according to one of the preceding claims, **characterized in that** the positional locking is effected by a projection (17), which preferably extends transversely to the longitudinal axis of the contact pin (13a, 13b) and preferably runs around the complete periphery, on the respective contact pin (13a, 13b) which engages in a complementary recess (8a, 8b) on the housing (2), or vice versa.

4. Multimeter according to one of the preceding claims, **characterized in that** the magnet arrangement comprises at least one magnet (7) arranged inside the housing (2) and locally associated with the respective first or second contact pin (13a, 13b).

5. Multimeter according to Claim 4, **characterized in that** a plurality of magnets (7) are associated with the respective first or second contact pin (13a, 13b).

6. Multimeter according to one of the preceding claims, **characterized in that** the magnet arrangement is fastened on the inner wall of the housing rear side (10).

7. Multimeter according to one of the preceding claims, **characterized in that** the magnets of the magnet arrangement are neodymium magnets.

8. Multimeter according to one of the preceding claims, **characterized in that** the respective contact pin (13a, 13b) has a plastic grip area (16) and the grip area (16) contains at least one ferromagnetic insert (15), preferably at least two ferromagnetic inserts.

9. Multimeter according to Claim 8, **characterized in that** the ferromagnetic insert (15) is encapsulated with plastic.

10. Multimeter according to one of the preceding claims, **characterized in that** the first or second contact pin (13a, 13b) has at least one rounded or flattened contact area (12) which extends essentially parallel to the axis of the contact pin (13a, 13b).

11. Multimeter according to Claim 10, **characterized in that** the first or second contact pin (13a, 13b) has three rounded or flattened contact areas (12) which extend essentially parallel to the axis of the contact pin (13a, 13b).

12. Multimeter according to one of the preceding claims, **characterized in that** a first and a second support depression (19a, 19b) for the first and second contact pin (13a, 13b) is provided on the housing rear side (10) in the region of the magnet arrangement.

13. Multimeter according to one of the preceding claims, **characterized in that** a stand (20) which can be pivoted out and can be positioned at an angle to the housing rear side is provided on the housing rear side (10), preferably below the region of the magnet arrangement.

## Revendications

1. Multimètre destiné à mesurer une pluralité de grandeurs électriques sélectionnables, ledit multimètre comprenant :
- un boîtier (2) comprenant un côté de boîtier avant (9) et un côté de boîtier arrière (10) opposé au côté de boîtier avant (9),
- un afficheur (3) destiné à afficher un réglage et/ou une valeur de mesure,
- une première ligne de mesure (6a) pourvue d'une première broche de contact (13a) en forme de tige,
- une deuxième ligne de mesure (6b) pourvue d'une deuxième broche de contact (13b) en forme de tige,
- un commutateur, de préférence un commutateur rotatif (4), destiné à sélectionner la grandeur électrique à mesurer,
- une première douille de raccordement (5a) destinée à raccorder la première ligne de mesure (6a), ainsi que
- une deuxième ligne de raccordement (5b) destinée à raccorder la deuxième ligne de mesure (6b),
- un ensemble d'aimants intégré dans le boîtier (2) permettant de fixer le multimètre (1) par son côté de boîtier arrière (10) à une surface d'appui ferromagnétique par une force d'attraction magnétique, et
- les première et deuxième broches de contact (13a, 13b) pouvant être fixées au côté de boîtier arrière (10) par une force d'attraction magnétique au moyen de l'ensemble d'aimants intégré au boîtier (2),
**caractérisé en ce que**
les première et deuxième broches de contact (13a, 13b) peuvent être fixées dans une première et une deuxième positions au côté de boîtier arrière (10), la première position étant une position de stockage, et la deuxième position étant une position de travail, au moins une des deux broches de contact (13a, 13b) étant fixée dans la position de travail de telle sorte que sa pointe dépasse du boîtier (2).

2. Multimètre selon la revendication 1, **caractérisé en ce qu'**en plus de la fixation au moyen de l'ensemble d'aimants dans la position de stockage et/ou dans la position de travail, un verrouillage de position mécanique de la broche de contact respective (13a, 13b) est prévu qui agit dans la direction longitudinale de la broche de contact respective (13a, 13b).

3. Multimètre selon l'une des revendications précédentes, **caractérisé en ce que** le verrouillage de position est réalisé par une saillie (17) qui est située sur la broche de contact respective (13a, 13b), qui s'étend de préférence transversalement à l'axe longitudinal de la broche de contact (13a, 13b), de préférence circonférentiellement, et qui s'engage dans un évidement complémentaire (8a, 8b) du boîtier (2) ou inversement.

4. Multimètre selon l'une des revendications précédentes, **caractérisé en ce que** l'ensemble d'aimants comprend au moins un aimant (7) disposé à l'intérieur du boîtier (2) et associé localement à la première ou la deuxième broche de contact respective (13a, 13b).

5. Multimètre selon la revendication 4, **caractérisé en ce que** plusieurs aimants (7) sont associés à la première ou la deuxième broche de contact respective (13a, 13b).

6. Multimètre selon l'une des revendications précédentes, **caractérisé en ce que** l'ensemble d'aimants est fixé à la paroi intérieure du côté de boîtier arrière (10).

7. Multimètre selon l'une des revendications précédentes, **caractérisé en ce que** les aimants de l'ensemble d'aimants sont des aimants en néodyme.

8. Multimètre selon l'une des revendications précédentes, **caractérisé en ce que** la broche de contact respective (13a, 13b) comporte une zone de préhension (16) en matière synthétique et la zone de préhension (16) contient au moins un insert ferromagnétique (15), de préférence au moins deux inserts ferromagnétiques.

9. Multimètre selon la revendication 8, **caractérisé en ce que** l'insert ferromagnétique (15) est encapsulé dans une matière synthétique.

10. Multimètre selon l'une des revendications précédentes, **caractérisé en ce que** la première ou la deuxième broche de contact (13a, 13b) comporte au moins une zone de contact arrondie ou aplatie (12) qui s'étend sensiblement parallèlement à l'axe de la broche de contact (13a, 13b).

11. Multimètre selon la revendication 10, **caractérisé en ce que** la première ou la deuxième broche de contact (13a, 13b) comporte trois zones de contact arrondies ou aplaties (12) qui s'étendent sensiblement parallèlement à l'axe de la broche de contact (13a, 13b).

12. Multimètre selon l'une des revendications précédentes, **caractérisé en ce que** des premier et deuxième évidements de support (19a, 19b) destinés aux première et deuxième broches de contact (13a, 13b) sont prévus sur le côté de boîtier arrière (10) dans la zone de l'ensemble d'aimants.

13. Multimètre selon l'une des revendications précédentes, **caractérisé en ce qu'**un pied de support pouvant être écarté par pivotement et positionné obliquement par rapport au côté de boîtier arrière (20) est prévu sur le côté de boîtier arrière (10), de préférence au-dessous de la zone de l'ensemble d'aimants.
